# EUROPEAN PATENT APPLICATION

(11) **EP 4 087 128 A1**
(43) Date of publication of application: **09.11.2022**
(21) Application number: 20909117.2
(22) Date of filing: 06.05.2020
(51) Int. Cl.: H03H 9/02

(54) **TEMPERATURE-COMPENSATING LAYER STRUCUTRE, BULK ACOUSTIC WAVE RESONATOR, AND FABRICATION METHODS, FILTER AND ELECTRONIC DEVICE**

(30) Priority: 31.12.2019 CN 201911424743
(71) Applicant: Rofs Microsystem (Tianjin) Co., Ltd, Tianjin 300462 (CN)
(72) Inventor: PANG, Wei, Tianjin 300072 (CN); YAN, Dehai, Tianjin 300462 (CN); ZHANG, Menglun, Tianjin 300072 (CN)
(74) Representative: Ström & Gulliksson AB
(86) International application number: PCT/CN2020/088727
(87) International publication number: WO 2021/135017

(57) **Abstract**

The present disclosure relates to a temperature-compensating layer structure, including a temperature-compensating layer, wherein the upper side of the end part of the temperature-compensating layer is an inclined surface so that the end part of the temperature-compensating layer is a wedge-shaped end surface, and an angle formed between the upper side of the end part of the temperature-compensating layer and the bottom side of the temperature-compensating layer is less than 60°; and an upper seed layer that covers over the temperature-compensating layer, wherein at least one end of the upper seed layer is provided with and extending part that extends to the outer side of the temperature-compensating layer. The present disclosure also relates to a bulk acoustic wave resonator, a fabrication method for the temperature-compensating layer, a fabrication method for the bulk acoustic wave resonator, a filter, and an electronic device.

## Description

### TECHNICAL FIELD

Embodiments of the present disclosure relate to the field of semiconductors, and in particular, to a temperature compensation layer structure and a manufacturing method thereof, a bulk acoustic wave resonator, a filter, and an electronic device.

### BACKGROUND

The current bulk acoustic wave resonators generally have a negative frequency temperature drift coefficient, which is about -30 PPM/K. This is because the piezoelectric materials and electrode materials of the bulk acoustic wave resonators have the negative frequency temperature drift coefficients. Accordingly, stiffness of these materials decreases with an increased temperature, and decreasing of the stiffness may cause a reduced sound speed. Considering V=F^{∗} λ=F^{∗}2d (where Visa sound speed, F is a frequency, λ is a wavelength, and d is a thickness of the piezoelectric layer), the frequency may decrease. However, when the temperature rises, the stiffness of Si02 and materials with a positive frequency temperature drift coefficient may increase. Therefore, it is possible to add a layer of Si02 or materials with a positive frequency temperature drift coefficient (i.e., a temperature compensation layer) to prevent decrease of the sound speed caused by the decreased resonator stiffness, thereby preventing frequency drift.

However, the temperature compensation layer has poor process compatibility during a manufacturing process, and damage to the temperature compensation layer can be easily caused by a post-production process of a FBAR. Therefore, it is a difficult issue in the industry to achieve a stable and complete temperature compensation layer in manufacturing.

### SUMMARY

In order to solve at least one aspect of the above technical problems in prior art, the present disclosure is provided.

According to an aspect of embodiments of the present disclosure, there is provided a temperature compensation layer structure that includes a temperature compensation layer and an upper seed layer covering the temperature compensation layer. An upper side of an end portion of the temperature compensation layer has an inclined surface such that the end portion of the temperature compensation layer has a wedge-shaped end face, and an angle formed between the upper side of the end portion of the temperature compensation layer and a bottom side of the temperature compensation layer is less than 60 degrees. At least one end portion of the upper seed layer includes an extension portion extending to outside of the temperature compensation layer.

According to another aspect of the embodiments of the present disclosure, a method of forming a temperature compensation layer structure is provided. The temperature compensation layer structure includes a temperature compensation layer and an upper seed layer covering the temperature compensation layer. The method includes providing a temperature compensation layer on a resonator material layer; patterning the temperature compensation layer to form an inclined surface at an upper side of an end portion of the temperature compensation layer such that the end portion of the temperature compensation layer has a wedge-shaped end face, and an angle formed between the upper side of the end portion of the temperature compensation layer and a bottom side of the temperature compensation layer being less than 60 degrees; providing the upper seed layer on the patterned temperature compensation layer, such that at least one end portion of the upper seed layer extends to outside of the temperature compensation layer and has an extension portion; and patterning the upper seed layer such that an extension length of the extension portion of the upper seed layer is a predetermined length.

According to another aspect of the embodiments of the present disclosure, a method of forming a temperature compensation layer structure is further provided. The temperature compensation layer structure includes a temperature compensation layer, a lower seed layer provided below the temperature compensation layer, and an upper seed layer covering the temperature compensation layer. The method includes sequentially providing a lower seed layer and a temperature compensation layer on a resonator material layer; patterning the temperature compensation layer and the lower seed layer to form an inclined surface at an upper side of an end portion of the temperature compensation layer, such that the end portion of the temperature compensation layer has a wedge-shaped end face and an end portion of the first seed layer is at least flush with the end portion of the temperature compensation layer, and an angle formed between the upper side of the end portion of the temperature compensation layer and a bottom side of the temperature compensation layer being less than 60 degrees; providing the upper seed layer on the patterned temperature compensation layer and lower seed layer, such that at least one end portion of the upper seed layer extends to outside of the temperature compensation layer and has an extension portion; and patterning the upper seed layer such that an extension length of the extension portion of the upper seed layer is a predetermined length.

According to a further aspect of an embodiment of the present disclosure, there is provided a bulk acoustic wave resonator that includes an acoustic mirror, a bottom electrode, a top electrode, and a piezoelectric layer. At least one of the bottom electrode, the piezoelectric layer and the top electrode is provided with the above temperature compensation layer structure.

According to a further aspect of the embodiments of the present disclosure, there is provided a filter that includes the above bulk acoustic wave resonator.

An embodiment of the present disclosure further relates to an electronic device including the filter or the temperature compensation layer structure as described above.

According to a further aspect of the embodiments of the present disclosure, there is provided a method of manufacturing a bulk acoustic wave resonator. The method includes forming the above temperature compensation layer structure on one resonator material layer; and providing another resonator material layer on the temperature compensation layer structure, the temperature compensation layer structure being wrapped by the one resonator material layer and the another resonator material layer.

### BRIEF DESCRIPTION OF DRAWINGS

The following description and drawings can facilitate to understand these and other features and advantages in various embodiments disclosed in the present disclosure. The same reference signs in the drawings always indicate the same components, wherein:
FIG. 1 is a schematic sectional view of a bulk acoustic wave resonator with a temperature compensation layer structure according to an exemplary embodiment of the present disclosure;
FIG. 2 is a partially enlarged schematic diagram of an end portion of the temperature compensation layer according to an exemplary embodiment of the present disclosure;
FIGS. 3A to 3G are schematic sectional views showing a manufacturing process of a bulk acoustic wave resonator according to an exemplary embodiment of the present disclosure;
FIGS. 4 to 6 are schematic sectional views respectively showing a bulk acoustic wave resonator with a temperature compensation layer, in which the temperature compensation layer is prone to have structural defects; and
FIG. 7 is a schematic sectional view of a bulk acoustic wave resonator according to an exemplary embodiment of the present disclosure.

### DESCRIPTION OF EMBODIMENTS

The technical solutions of the present disclosure will be further described below in detail through embodiments and in conjunction with the drawings. The same or similar reference signs indicate the same or similar components throughout the description. The following description of embodiments of the present disclosure with reference to the drawings is intended to explain the general inventive concept of the present disclosure, and should not be construed as a limitation to the present disclosure.

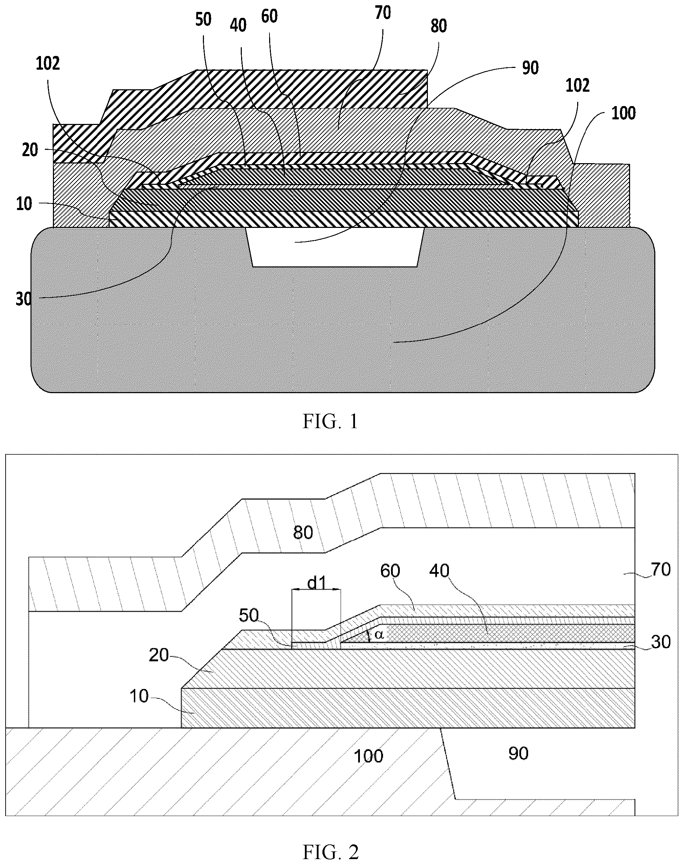

FIG. 1 is a schematic sectional view of a bulk acoustic wave resonator with a temperature compensation layer structure according to an exemplary embodiment of the present disclosure. In FIGS. 1, reference numbers are described below.
10: First seed layer, which is made of a material such as aluminum nitride, zinc oxide, and PZT and contains the above materials doped with a certain atomic ratio of rare earth element.
20: Bottom electrode, which may be made of molybdenum, ruthenium, gold, aluminum, magnesium, tungsten, copper, titanium, iridium, osmium, chromium, or composites or alloys thereof.
30: Second seed layer, which is made of a material such as aluminum nitride, zinc oxide, and PZT and contains the above materials doped with a certain atomic ratio of rare earth element or silicon nitride.
40: Temperature compensation layer, which may be made of a material with a positive frequency temperature drift coefficient, such as Si02.
50: Third seed layer, which is made of a material such as aluminum nitride, zinc oxide, and PZT and contains the above materials doped with a certain atomic ratio of rare earth element or silicon nitride.
60: Interlayer electrode or intermediate electrode, which is made of a material such as molybdenum, ruthenium, gold, aluminum, magnesium, tungsten, copper, titanium, iridium, osmium, chromium, or composites or alloys thereof.
70: Piezoelectric film, which is made of a material such as aluminum nitride, zinc oxide, and PZT and contains the above materials doped with a certain atomic ratio of rare earth element.
80: Top electrode, which is made of a material such as molybdenum, ruthenium, gold, aluminum, magnesium, tungsten, copper, titanium, iridium, osmium, chromium, or composites or alloys thereof.
90: Acoustic mirror, which may be a cavity, or adopt a Bragg reflection layer and other equivalent forms. The cavity is adopted in the present disclosure.
100: Substrate, which is made of a material such as monocrystalline silicon, gallium arsenide, sapphire, or quartz.
102: Tail portion of the third seed layer, in which a lateral dimension of the third seed layer is larger than that of the temperature compensation layer.

FIG. 2 is a partially enlarged schematic diagram of an end portion of the temperature compensation layer according to an exemplary embodiment of the present disclosure.

The embodiments shown in FIGS. 1 and 2 are described below.

As shown in FIG. 1, the lateral dimension of the third seed layer 50 is larger than that of the temperature compensation layer. In other words, the temperature compensation layer 40 is completely wrapped by the third seed layer 50 and the second seed layer 30, and a dimension d1 of a tail portion structure (i.e., an extension portion) 102 is in a range of 0.5 µm to 5 µm.

A tangent angle α of the temperature compensation layer 40 is less than 20 degrees. In other words, an upper side surface of the end portion of the temperature compensation layer is an inclined surface such that the end portion of the temperature compensation layer has a wedge-shaped end face. An angle α formed between the inclined surface and a bottom surface of the temperature compensation layer is less than 20 degrees, further in a range of 8 to 12 degrees.

It should be noted that FIG. 1 and FIG. 2 show preferred embodiments of the present disclosure, which can vary in the present disclosure. For example, the angle α may be in other angle ranges, such as less than 60 degrees. The temperature compensation layer may be provided with only the third seed layer 50 (i.e. an upper seed layer) without the second seed layer 30 (i.e. a lower seed layer). The second seed layer may extend to outside of the temperature compensation layer, such that the extension portion of the third seed layer at least partially overlap an end portion of the second seed layer.

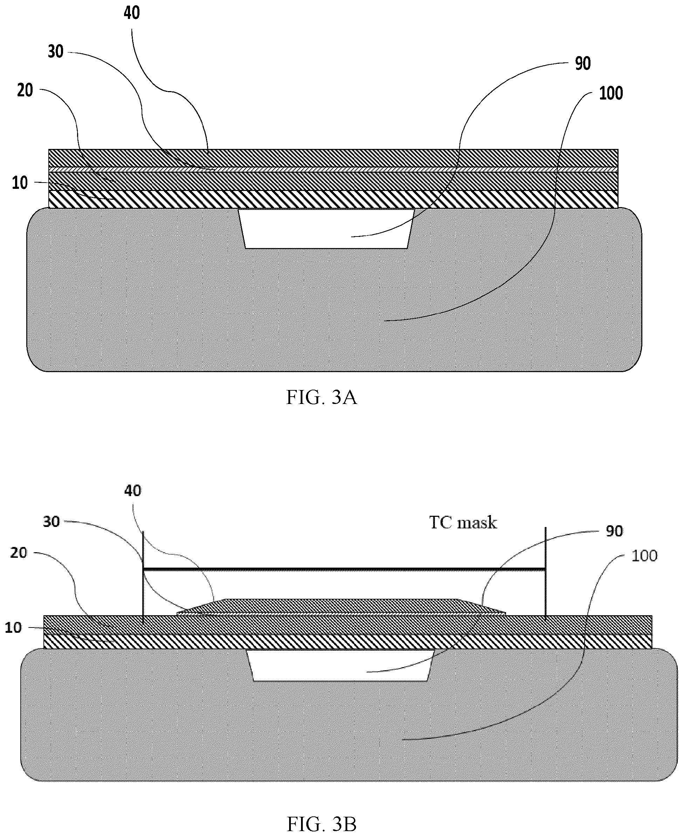

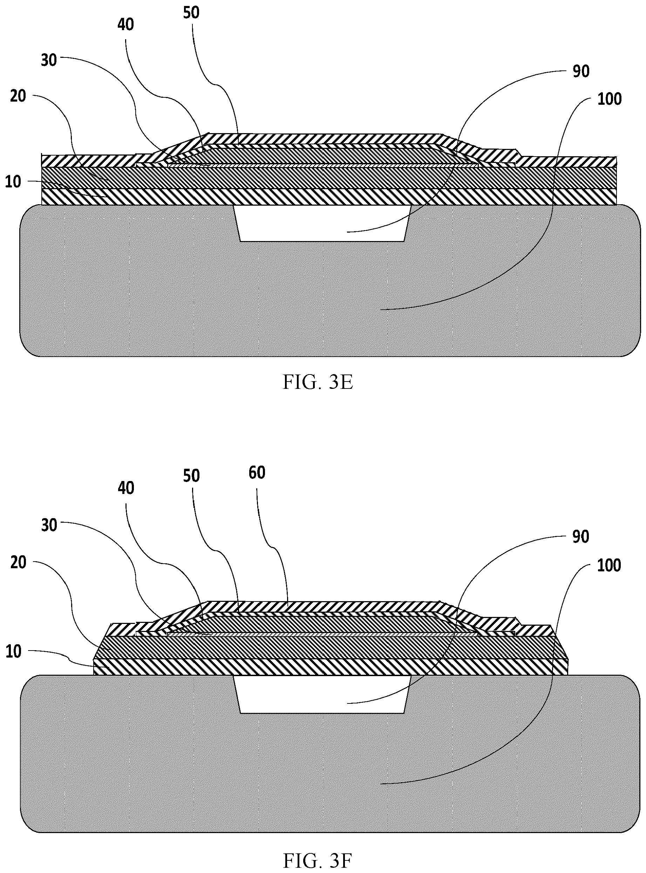

It should also be noted that in the embodiments shown in FIGS. 1 and 2, a structure of the resonator is merely exemplary, and accordingly, the manufacturing method of the resonator in FIGS. 3A to 3G is merely exemplary. For example, there are different forms or changes in FIGS. 3F to 3G. In addition, steps of a manufacturing method of a corresponding resonator can vary based on different positions of the temperature compensation layer.

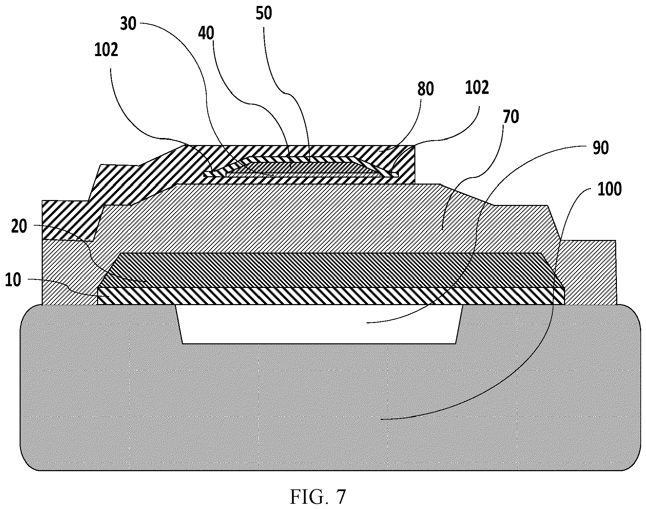

In the embodiments shown in FIGS. 1 to 2, the temperature compensation layer is provided in the bottom electrode, but the present disclosure is not limited to this. For example, the temperature compensation layer is arranged in the top electrode as shown in FIGS. 7. In addition, although not shown, the temperature compensation layer may be formed in the piezoelectric layer. All of the above embodiments fall within the scope of the present disclosure.

In the present disclosure, one or both of end portions of each of the temperature compensation layer and the seed layers does not mean that the temperature compensation layer and the seed layers each have a strip structure to have ends in a longitudinal direction, but means that there is at least one sectional view and two end portions of the temperature compensation layer or the seed layers in this sectional view correspond to ends of the temperature compensation layer or the seed layers. As can be understood by those skilled in the art, the temperature compensation layer and the seed layers each have a planar structure, and the end portions of the temperature compensation layer and the seed layers are edges of the planar structures.

It should be noted that, in the present disclosure, a shape of the end portion of the temperature compensation layer is illustrated and described by taking the wedge-shaped end face as an example. However, the wedge-shaped end face includes various embodiments of a tapered end face (i.e., gradually tapering toward the outside). The wedge-shaped end face is formed in such a manner that it not only includes an inclined angle formed between a pure inclined surface and the bottom surface of the temperature compensation layer, but also includes that the inclined surface is formed by connecting lines between upper points and lower points of an arc-shaped surface when the tapered end face is formed by the arc-shaped surface. All of the above embodiments fall within the scope of the present disclosure.

FIGS. 3A to 3G are schematic sectional views showing a manufacturing process of a bulk acoustic wave resonator according to an exemplary embodiment of the present disclosure. The manufacturing process of the bulk acoustic wave resonator will be described illustratively below. As can be understood by those skilled in the art, the manufacturing process includes a manufacturing process of the temperature compensation layer.

Firstly, as shown in FIGS. 3A, the substrate 100 is integrally grown to the temperature compensation layer 40.

Next, as shown in FIGS. 3B, the temperature compensation layer 40 and the second seed layer 30 are etched with a temperature compensation layer mask.

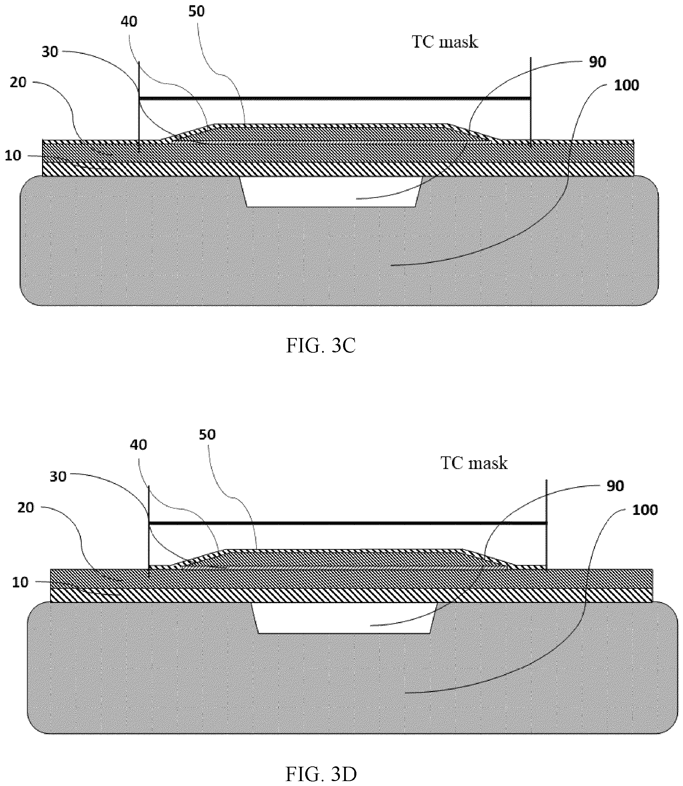

Then, as shown in FIGS. 3C, a third seed layer 50 is grown.

Thereafter, as shown in FIGS. 3D, the third seed layer 50 is etched with the same mask as the temperature compensation layer, but the mask for the third seed layer has a dimension that is larger than the mask for the temperature compensation layer, to form the tail portion of the third seed layer (i.e. extension portion).

As shown in FIGS. 3E, an interlayer electrode 60 is grown.

As shown in FIGS. 3F, the interlayer electrode 60 and the bottom electrode 20 are etched.

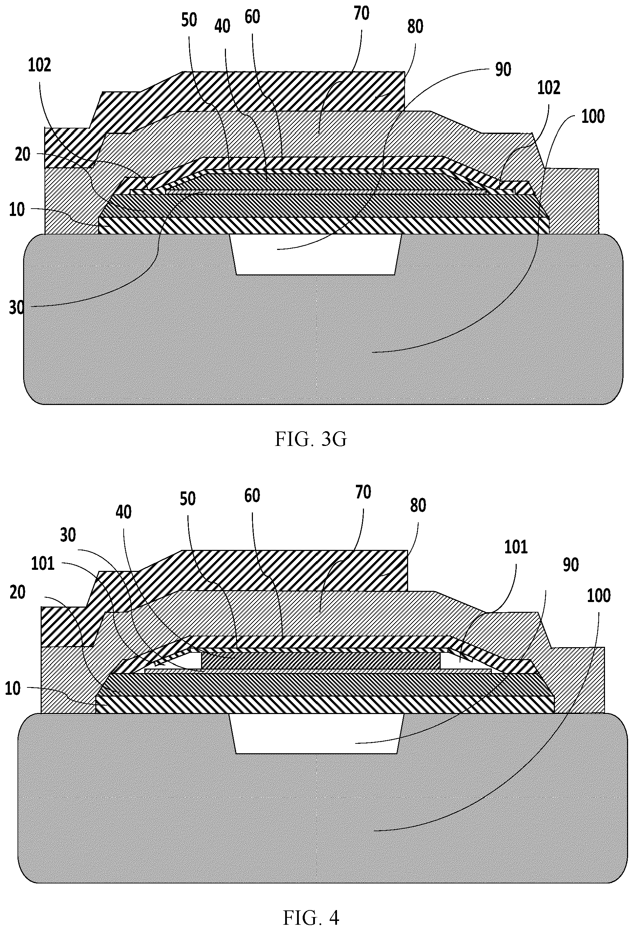

Finally, as shown in FIGS. 3G, the piezoelectric layer 70 is grown and the top electrode 80 is etched, to form a complete bulk acoustic wave resonator structure.

FIGS. 4 to 6 are schematic sectional views respectively showing a bulk acoustic wave resonator with a temperature compensation layer, in which the temperature compensation layer is prone to have structural defects.

As shown in FIGS. 4, the second seed layer 30 and the third seed layer 50 do not completely wrap the temperature compensation layer 40. If an electrode material with a poor crystal orientation is used to perform wrapping, integrity of wrapping is reduced, resulting in an air gap 101. Accordingly, a dimension of the air gap cannot be controlled, and thus an electromechanical coupling coefficient is reduced. In the exemplary structure of the present disclosure, the second seed layer 30 and the third seed layer 50 completely wrap the temperature compensation layer 40, such that the temperature compensation layer will be not damaged by subsequent wet processes and a stable temperature compensation structure is obtained.

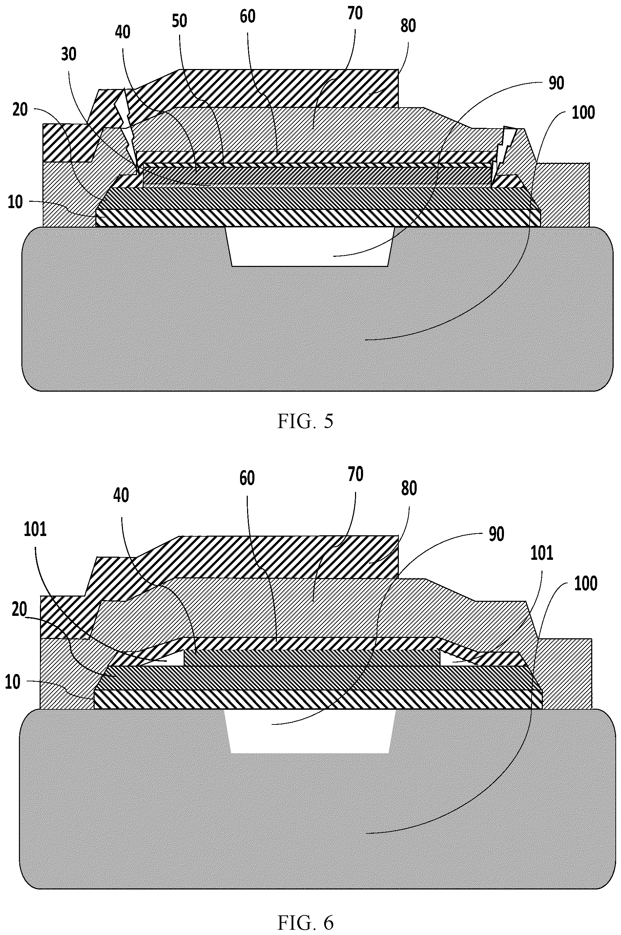

As shown in FIGS. 5, a tangent angle α at an edge of the temperature compensation layer is relatively large, for example, more than 70 degrees. As for an substantially vertical tangent angle as shown in FIG. 5, this excessively large angle may cause the piezoelectric layer to break due to consistent crystal orientation of piezoelectric materials, thereby affecting a series resonance impedance of the resonator and a quality factor of the resonator.

As shown in FIG. 6, the temperature compensation layer is easily damaged by the subsequent wet processes, and the crystal orientation of the temperature compensation material is poor. Accordingly, if only the electrode material with the poor crystal orientation is used to perform wrapping, the poor crystal orientation may be transferred to the piezoelectric layer and thus reduce the quality factor of the resonator. Moreover, even if the electrode material serves to wrap the temperature compensation layer, the temperature compensation layer may still be damaged by the subsequent processes and the air gap 101 is formed. In an exemplary embodiment, the temperature compensation layer structure of the present disclosure includes the second seed layer 30 and the third seed layer 50 to completely wrap the temperature compensation layer 40, and then the interlayer electrode wraps the whole temperature compensation layer. In this way, the temperature compensation layer is prevented from being damaged by the subsequent wet processes, and the interlayer electrode has a good crystal orientation due to presence of the third seed layer, such that the piezoelectric layer can obtain a good crystal orientation and further the resonator performance is not affected.

In view of the above, the present disclosure provides following technical solutions.
1. A temperature compensation layer structure includes:
   a temperature compensation layer having an inclined surface at an upper side of an end portion thereof such that the end portion of the temperature compensation layer has a wedge-shaped end face, an angle formed between the upper side of the end portion of the temperature compensation layer and a bottom side of the temperature compensation layer being less than 60 degrees; and
   an upper seed layer covering the temperature compensation layer,
   wherein
   at least one end portion of the upper seed layer includes an extension portion extending to outside of the temperature compensation layer.
2. The temperature compensation layer structure according to 1, wherein
   the temperature compensation layer structure further includes a lower seed layer provided below the temperature compensation layer, and an end portion of the lower seed layer is at least flush with the end portion of the temperature compensation layer; and
   the temperature compensation layer is wrapped between the upper seed layer and the lower seed layer in a thickness direction.
3. The temperature compensation layer structure according to 2, wherein
   the extension portion of the upper seed layer extends to outside of the lower seed layer, and is arranged in a same layer as the lower seed layer.
4. The temperature compensation layer structure according to any one of 1 to 3, wherein
   the extension portion has an extension length in a range of 0.5 µm to 5 µm.
5. The temperature compensation layer structure according to any one of 1 to 4, wherein
   each of two end portions of the upper seed layer includes the extension portion.
6. The temperature compensation layer structure according to any one of 1 to 5, wherein
   the angle formed between the upper side of the end portion of the temperature compensation layer and the bottom side of the temperature compensation layer is not more than 20 degrees.
7. The temperature compensation layer structure according to 1, wherein
   the angle formed between the upper side of the end portion of the temperature compensation layer and the bottom side of the temperature compensation layer is in a range of 8 to 12 degrees.
8. A method of forming a temperature compensation layer structure is provided, and the temperature compensation layer structure includes a temperature compensation layer and an upper seed layer covering the temperature compensation layer. The method includes:
   providing a temperature compensation layer on a resonator material layer;
   patterning the temperature compensation layer to form an inclined surface at an upper side of an end portion of the temperature compensation layer such that the end portion of the temperature compensation layer has a wedge-shaped end face, and an angle formed between the upper side of the end portion of the temperature compensation layer and a bottom side of the temperature compensation layer being less than 60 degrees;
   providing the upper seed layer on the patterned temperature compensation layer, such that at least one end portion of the upper seed layer extends to outside of the temperature compensation layer and has an extension portion; and
   patterning the upper seed layer such that an extension length of the extension portion of the upper seed layer is a predetermined length.
9. A method of forming a temperature compensation layer structure is provided, and the temperature compensation layer structure includes a temperature compensation layer, a lower seed layer provided below the temperature compensation layer, and an upper seed layer covering the temperature compensation layer. The method includes:
   sequentially providing a lower seed layer and a temperature compensation layer on a resonator material layer;
   patterning the temperature compensation layer and the lower seed layer to form an inclined surface at an upper side of an end portion of the temperature compensation layer, such that the end portion of the temperature compensation layer has a wedge-shaped end face and an end portion of the first seed layer is at least flush with the end portion of the temperature compensation layer, and an angle formed between the upper side of the end portion of the temperature compensation layer and a bottom side of the temperature compensation layer being less than 60 degrees;
   providing the upper seed layer on the patterned temperature compensation layer and lower seed layer, such that at least one end portion of the upper seed layer extends to outside of the temperature compensation layer and has an extension portion; and
   patterning the upper seed layer such that an extension length of the extension portion of the upper seed layer is a predetermined length.
10. The method according to 9, wherein
   in the providing the upper seed layer on the patterned temperature compensation layer and lower seed layer, the extension portion of the upper seed layer extends to outside of the lower seed layer, and is arranged in a same layer as the lower seed layer.
11. The method according to any one of 8 to 10, wherein
   in the patterning the temperature compensation layer, the upper side of the end portion of the temperature compensation layer has the inclined surface such that the end portion of the temperature compensation layer has the wedge-shaped end face.
12. A bulk acoustic wave resonator includes:
   an acoustic mirror;
   a bottom electrode;
   a top electrode; and
   a piezoelectric layer,
   wherein
   at least one of the bottom electrode, the piezoelectric layer and the top electrode is provided with the temperature compensation layer structure according to any one of 1 to 7.
13. A filter includes the bulk acoustic wave resonator according to 12.
14. An electronic device includes the filter according to 13 or the temperature compensation layer structure according to any one of 1 to 7.
15. A method of manufacturing a bulk acoustic wave resonator includes:
   forming the temperature compensation layer structure according to any one of 1 to 7 on one resonator material layer; and
   providing another resonator material layer on the temperature compensation layer structure, the temperature compensation layer structure being wrapped by the one resonator material layer and the another resonator material layer.
16. The method according to 15, wherein
   the one resonator material layer and the another resonator material layer are both piezoelectric layer materials or electrode materials.

It should be noted that the electronic device herein includes, but is not limited to, intermediate products such as an RF front end, filter and amplifier modules, and terminal products such as mobile phones, WIFI, and drones.

Although the embodiments of the present disclosure have been shown and described, it should be understood for those skilled in the art that modifications may be made to these embodiments without departing from the principle and spirit of the present disclosure, and the scope thereof is defined by the appended claims and their equivalents.

## Claims

1. A temperature compensation layer structure, comprising:
a temperature compensation layer having an inclined surface at an upper side of an end portion thereof in such a manner that the end portion of the temperature compensation layer has a wedge-shaped end face, an angle formed between the upper side of the end portion of the temperature compensation layer and a bottom side of the temperature compensation layer being less than 60 degrees; and
an upper seed layer covering the temperature compensation layer,
wherein at least one end portion of the upper seed layer comprises an extension portion extending to outside of the temperature compensation layer.

2. The temperature compensation layer structure according to claim 1, further comprising:
a lower seed layer provided below the temperature compensation layer, an end portion of the lower seed layer being at least flush with the end portion of the temperature compensation layer,
wherein the temperature compensation layer is wrapped between the upper seed layer and the lower seed layer in a thickness direction.

3. The temperature compensation layer structure according to claim 2, wherein the extension portion of the upper seed layer extends to outside of the lower seed layer, and is arranged in a same layer as the lower seed layer.

4. The temperature compensation layer structure according to any one of claims 1 to 3, wherein the extension portion has an extension length in a range of 0.5 µm to 5 µm.

5. The temperature compensation layer structure according to any one of claims 1 to 4, wherein each of two end portions of the upper seed layer includes the extension portion.

6. The temperature compensation layer structure according to any one of claims 1 to 5, wherein the angle formed between the upper side of the end portion of the temperature compensation layer and the bottom side of the temperature compensation layer is not more than 20 degrees.

7. The temperature compensation layer structure according to claim 1, wherein the angle formed between the upper side of the end portion of the temperature compensation layer and the bottom side of the temperature compensation layer is in a range of 8 to 12 degrees.

8. A method of forming a temperature compensation layer structure, wherein the temperature compensation layer structure comprises a temperature compensation layer and an upper seed layer covering the temperature compensation layer, the method comprises:
providing a temperature compensation layer on a resonator material layer;
patterning the temperature compensation layer to form an inclined surface at an upper side of an end portion of the temperature compensation layer in such a manner that the end portion of the temperature compensation layer has a wedge-shaped end face, an angle formed between the upper side of the end portion of the temperature compensation layer and a bottom side of the temperature compensation layer being less than 60 degrees;
providing the upper seed layer on the patterned temperature compensation layer, in such a manner that at least one end portion of the upper seed layer extends to outside of the temperature compensation layer and has an extension portion; and
patterning the upper seed layer in such a manner that an extension length of the extension portion of the upper seed layer is a predetermined length.

9. A method of forming a temperature compensation layer structure, wherein the temperature compensation layer structure comprises a temperature compensation layer, a lower seed layer provided below the temperature compensation layer, and an upper seed layer covering the temperature compensation layer, the method comprises:
sequentially providing a lower seed layer and a temperature compensation layer on a resonator material layer;
patterning the temperature compensation layer and the lower seed layer to form an inclined surface at an upper side of an end portion of the temperature compensation layer, in such a manner that the end portion of the temperature compensation layer has a wedge-shaped end face and an end portion of the first seed layer is at least flush with the end portion of the temperature compensation layer, an angle formed between the upper side of the end portion of the temperature compensation layer and a bottom side of the temperature compensation layer being less than 60 degrees;
providing the upper seed layer on the patterned temperature compensation layer and lower seed layer in such a manner that at least one end portion of the upper seed layer extends to outside of the temperature compensation layer and has an extension portion; and
patterning the upper seed layer in such a manner that an extension length of the extension portion of the upper seed layer is a predetermined length.

10. The method according to claim 9, wherein in the providing the upper seed layer on the patterned temperature compensation layer and lower seed layer, the extension portion of the upper seed layer extends to outside of the lower seed layer, and is arranged in a same layer as the lower seed layer.

11. The method according to any one of claims 8 to 10, wherein in the patterning the temperature compensation layer, the upper side of the end portion of the temperature compensation layer has the inclined surface in such a manner that the end portion of the temperature compensation layer has the wedge-shaped end face.

12. A bulk acoustic wave resonator, comprising:
an acoustic mirror;
a bottom electrode;
a top electrode; and
a piezoelectric layer,
wherein at least one of the bottom electrode, the piezoelectric layer and the top electrode is provided with the temperature compensation layer structure according to any one of claims 1 to 7.

13. A filter, comprising the bulk acoustic wave resonator according to claim 12.

14. An electronic device, comprising the filter according to claim 13 or the temperature compensation layer structure according to any one of claims 1 to 7.

15. A method of manufacturing a bulk acoustic wave resonator, comprising:
forming the temperature compensation layer structure according to any one of claims 1 to 7 on one resonator material layer; and
providing another resonator material layer on the temperature compensation layer structure, the temperature compensation layer structure being wrapped by the one resonator material layer and the another resonator material layer.

16. The method according to claim 15, wherein the one resonator material layer and the another resonator material layer are both piezoelectric layer materials or electrode materials.
